# EUROPÄISCHE PATENTANMELDUNG

(11) **EP 4 181 640 A1**
(43) Veröffentlichungstag der Anmeldung: **17.05.2023**
(21) Anmeldenummer: 22203559.4
(22) Anmeldetag: 25.10.2022
(51) Int. Cl.: H05K 5/06, H05K 7/14, H05K 7/20

(54) **LEISTUNGSELEKTRONISCHE KOMPONENTE**

(30) Priorität: 12.11.2021 DE 102021129591
(71) Anmelder: STILL GmbH, 22113 Hamburg (DE)
(72) Erfinder: ALTHOF, Carsten, 21031 Hamburg (DE); OSPER, Gerald, 22147 Hamburg (DE); SCHETTGEN, Nils, 22559 Hamburg (DE)
(74) Vertreter: Patentship Patentanwaltgesellschaft

(57) **Zusammenfassung**

Die Erfindung betrifft eine leistungselektronische Komponente (C) mit einem Grundkörper (8) und einem Gehäuse (5) sowie mindestens einer im Gehäuse (5) untergebrachten Leiterplatte (7) und mindestens einer elektrischen Kontaktierung der Leiterplatte (7) zu einem, außerhalb des Gehäuses (5) vorgesehenen, leistungselektronischen Anschluss. Es wird vorgeschlagen, dass die elektrische Kontaktierung der Leiterplatte (7) eine elektrisch leitende Hülse (3) umfasst, die auf die Leiterplatte (7) kontaktiert und aus dem Gehäuse (5) herausgeführt ist, wobei in die elektrisch leitende Hülse (3) eine isolierte Schraube (1) eingesetzt ist, die in eine Gewindebohrung (9) im Grundkörper (8) geschraubt ist und deren Schraubenkopf ein Anschlusselement (2) des leistungselektronischen Anschlusses auf die Hülse (3) und gegen das Gehäuse (5) presst, wobei die Hülse (3) frei von einem elektrischen Kontakt mit dem Grundkörper (8) ist.

## Beschreibung

Die Erfindung betrifft eine leistungselektronische Komponente mit einem Grundkörper und einem Gehäuse sowie mindestens einer im Gehäuse untergebrachten Leiterplatte und mindestens einer elektrischen Kontaktierung der Leiterplatte zu einem, außerhalb des Gehäuses vorgesehenen, leistungselektronischen Anschluss.

In bekannten leistungselektronischen Komponenten, wie zum Beispiel Umrichtern zur Ansteuerung von elektrischen Maschinen, sind die Funktionen der elektrischen Kontaktierung eines leistungselektronischen Anschlusses und der internen Befestigung von Leiterplatten auf einer Grundplatte oder dem Gehäuse generell als voneinander unabhängige Funktionen ausgeführt. Leiterplatten werden in der Regel verschraubt oder geclipst. Leistungselektronische Anschlüsse werden als Einpressbolzen in der Leiterplatte oder als eingelötete Buchsen oder Stromschienen ausgeführt.

Die bekannte Aufbautechnik von leistungselektronischen Komponenten erfordert eine Vielzahl von Verschraubungen und Verbindungselementen, um die Leiterplatten zu fixieren und Leistungsverbindungen gedichtet nach außen zu führen.

Der vorliegenden Erfindung liegt die Aufgabe zugrunde, eine leistungselektronische Komponente zur Verfügung zu stellen, die eine Verringerung der Anzahl der Verschraubungen und Verbindungselemente ermöglicht.

Diese Aufgabe wird erfindungsgemäß dadurch gelöst, dass die elektrische Kontaktierung der Leiterplatte eine elektrisch leitende Hülse umfasst, die auf die Leiterplatte kontaktiert und aus dem Gehäuse herausgeführt ist, wobei in die elektrisch leitende Hülse eine isolierte Schraube eingesetzt ist, die in eine Gewindebohrung im Grundkörper geschraubt ist und deren Schraubenkopf ein Anschlusselement des leistungselektronischen Anschlusses auf die Hülse und gegen das Gehäuse presst, wobei die Hülse frei von einem elektrischen Kontakt mit dem Grundkörper ist.

Die isolierte, bevorzugt elektrisch isolierte, Schraube kann vorzugsweise einen Schraubenschaft und den Schraubenkopf an einem Ende des Schraubenschaftes umfassen. Insbesondere kann der Schraubenkopf ein Kinn, das eine untere Ringfläche des Schraubenkopfes beschreibt, umfassen, das insbesondere ausgebildet ist, um eine Kraftübertragung auf ein zu befestigendes Bauteil zu ermöglichen. Unter einer Unterseite eines Schraubenkopfes kann vorzugsweise eine Seite verstanden werden, die einem zu befestigenden Bauteil zugewandt ist.

Insbesondere bevorzugt kann die untere Ringfläche des Schraubenkopfes eine Anlagefläche definieren, die das Anschlusselement auf die Hülse und gegen das Gehäuse presst.

Mit dieser Ausbildung der leistungselektronischen Komponente kann insbesondere erreicht werden, dass eine elektrische Verbindung zwischen dem Anschlusselement des leistungselektronischen Anschlusses und der Leiterplatte hergestellt wird, aber nicht zwischen der Hülse und dem Grundkörper. Gleichzeitig kann insbesondere durch den Anpressdruck der elektrisch isolierten Schraube eine Abdichtung zwischen dem Gehäuse und dem Anschlusselement gewährleistet werden. Zudem kann insbesondere mit der Schraube eine Fixierung der Leiterplatte am Grundkörper erzielt werden.

Zweckmäßigerweise umfasst das Anschlusselement einen Kabelschuh. Dabei kann der Kabelschuh vorteilhafterweise mit einer umlaufenden Isolierung versehen sein. Insbesondere bevorzugt kann der Kabelschuh zumindest teilweise oder vollständig von einer Isolierung umgeben sein.

Insbesondere bevorzugt kann die untere Ringfläche des Schraubenkopfes eine erste Anlagefläche definieren, die vorzugsweise ausgebildet ist, um mit dem Anschlusselement derart in Verbindung gebracht zu werden, dass das Anschlusselement auf die Hülse gepresst wird, und/oder eine zweite Anlagefläche definieren, die vorzugsweise ausgebildet ist, um mit der Isolierung bzw. Abdichtung des Anschlusselements derart in Verbindung gebracht zu werden, dass das Anschlusselement mit der Isolierung bzw. Abdichtung gegen eine Oberseite des Gehäuses gepresst wird.

Gemäß einer bevorzugten Ausgestaltung ist vorgesehen, dass das Gehäuse im Bereich des Schraubenkopfes eine Ausformung aufweist, die für eine Aufnahme des Schraubenkopfes und des Anschlusselements ausgebildet ist. Dadurch kann insbesondere ein optimaler Sitz des Schraubenkopfes der Schraube im Gehäuse gewährleistet werden oder zumindest der Sitz des Schraubenkopfes der Schraube im Gehäuse optimiert werden.

Von Vorteil ist auch insbesondere, dass die Leiterplatte mittels der Schraube auf den Grundkörper gepresst ist. Die Leiterplatte kann hierzu vorteilhafterweise eine Ausnehmung aufweisen, durch die die isolierte Schraube hindurchgeführt ist.

Besonders bevorzugt kann der Grundkörper als Grundplatte ausgebildet sein.

Außerdem umfasst der Grundkörper bevorzugt einen Kühlkörper. Hierzu kann der Grundkörper insbesondere selbst als Kühlkörper ausgebildet sein oder über einen Kühlkörper verfügen, der beispielsweise in den Grundkörper integriert ist oder direkt am Grundkörper angebracht ist. Durch das Andrücken der Leiterplatte an den Grundkörper kann vorzugsweise ein guter thermischer Kontakt zwischen der Leiterplatte und dem Grundkörper und somit eine zuverlässige Abführung der beim Betrieb der leistungselektronischen Komponente anfallenden Abwärme gewährleistet werden.

Gemäß einer weiter bevorzugten Ausführungsvariante kann die Hülse auf der Leiterplatte verlötet oder eingepresst sein. Dadurch kann ein besonders guter und zuverlässiger elektrischer Kontakt gewährleistet werden.

Gemäß einer Weiterbildung der Erfindung ist oberhalb der Leiterplatte mindestens eine weitere Leiterplatte vorgesehen, durch die die Hülse hindurchgeführt ist. Beispielsweise kann es sich bei einer Ausbildung der leistungselektronischen Komponente als Umrichter bei der zu fixierenden unteren Leiterplatte um ein Leistungsmodul mit Leistungshalbleitern handeln. Insbesondere bevorzugt kann es sich bei der, insbesondere in einer parallelen Ebene, darüber angeordneten Leiterplatte um ein Gleichspannungszwischenkreismodul mit Zwischenkreiskondensatoren handeln.

Dabei ist auf der weiteren Leiterplatte vorzugsweise ein Stromsensor oder ein Ferritkern im Bereich der Durchführung der Hülse angeordnet.

Durch die Durchführung der Hülse durch die obere Leiterplatte wird es insbesondere ermöglicht, auf dieser oberen Leiterplatte einen Stromsensorkern zur Strommessung oder einen Ferritkern zur Bedämpfung von elektromagnetischen Störungen zu platzieren.

Eine weitere Ausgestaltung der Erfindung sieht vor, dass der Öffnungsbereich der Gewindebohrung aufgeweitet ist. Auf diese Weise wird in diesem Bereich ein Luftspalt gebildet, wodurch die Gefahr von elektrischen Kriechströmen reduziert wird.

Zur Erleichterung der Montage der leistungselektronischen Komponente können vorzugsweise zusätzliche Halterungen vorgesehen sein, durch die die Leiterplatte und die Hülse in einer Ebene fixiert sind. Diese Halterungen können insbesondere ausgebildet sein, um nach der Montage bestehen bleiben zu können.

Alternativ oder zusätzlich kann die Montage dadurch erleichtert werden, dass die Leiterplatte und/oder die Hülse im unmontierten Zustand schwimmend gelagert sind.

In einem besonders bevorzugten Anwendungsfall ist die leistungselektronische Komponente als Umrichter ausgebildet. Umrichter kommen insbesondere zum Ansteuern von elektrischen Maschinen, zum Beispiel von elektrischen Antriebsmotoren von batterie-elektrisch betriebenen Fahrzeugen, insbesondere Flurförderzeugen, zum Einsatz.

Eine andere Anwendungsmöglichkeit für die Erfindung besteht darin, dass die leistungselektronische Komponente als Ladegerät ausgebildet ist. Ladegeräte werden zum Beispiel zum Laden von Traktionsbatterien von batterie-elektrisch betriebenen Fahrzeugen, insbesondere Flurförderzeugen, verwendet.

Der wesentliche Vorteil der Erfindung besteht darin, dass für die Funktion der elektrischen Kontaktierung, für die Funktion der Abdichtung des Anschlusselements am Gehäuse und für die Funktion der Fixierung der Leiterplatte auf dem Grundkörper der leistungselektronischen Komponente insbesondere nur noch eine einzige Schraubverbindung mit einer elektrisch isolierten Schraube benötigt wird. Dies bringt einen großen Kostenvorteil, da viele sonst benötigte Bauteile entfallen können.

Weitere Vorteile und Einzelheiten der Erfindung werden beispielhaft anhand des in der schematischen Figur dargestellten Ausführungsbeispiels näher erläutert.

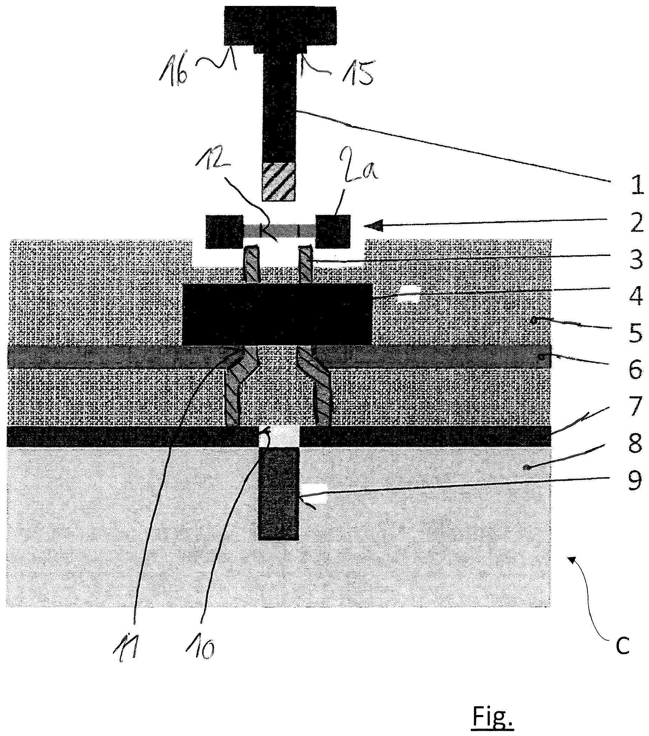

Die Figur zeigt eine, beispielsweise als Umrichter ausgebildete, leistungselektronische Komponente C mit einem, aus isolierendem Material, insbesondere aus Kunststoff, bestehenden Gehäuse 5 und einem, als Grundplatte ausgebildeten, Grundkörper 8. Der Grundkörper 8 kann als Kühlkörper zur Abführung der beim Betrieb der leistungselektronischen Komponente C anfallenden Abwärme ausgeführt sein.

Die leistungselektronische Komponente C weist eine untere Leiterplatte 7 auf, auf der Leistungshalbleiter, insbesondere Leistungstransistoren, angeordnet sind. Die untere Leiterplatte 7 steht mit dem Grundkörper 8 in Kontakt. In einer parallelen Ebene über der unteren Leiterplatte 7 ist im dargestellten Ausführungsbeispiel eine weitere Leiterplatte 6 angeordnet, auf der sich beispielsweise Zwischenkreiskondensatoren befinden.

Zum Fixieren der Leiterplatte 7 am Grundkörper 8 und zur Übertragung elektrischer Energie ist eine elektrisch leitende Hülse 3 vorgesehen, die mit ihrem unteren Ende die untere Leiterplatte 7 kontaktiert und auf der Leiterplatte 7 aufsteht. Die Hülse 3 kann hierzu mit der Leiterplatte 7 verlötet oder verpresst sein. Die Hülse 3 ist mit ihrem oberen Ende aus dem Gehäuse 5 herausgeführt.

Vom oberen Ende der Hülse 3 her ist eine elektrisch isolierte Schraube 1 in die Hülse 3 eingeführt, die in eine Gewindebohrung 9 des Grundkörpers 8 eingeschraubt ist. Die elektrisch isolierte Schraube 1 ist hierzu durch eine Ausnehmung der unteren Leiterplatte 7 hindurchgeführt.

Für die Zufuhr der elektrischen Energie, beispielsweise von einer externen Batterie, oder für die Abfuhr von elektrischer Energie, beispielsweise zu einer Motorphase eines von der leistungselektronischen Komponente C angesteuerten elektrischen Maschine, ist ein Anschlusselement 2 eines leistungselektronischen Anschlusses vorgesehen. Als Anschlusselement 2 ist im dargestellten Ausführungsbeispiel ein Kabelschuh eines elektrischen Anschlusskabels vorgesehen. Das Anschlusselement 2 weist eine angespritzte, umlaufende Isolierung bzw. Abdichtung 2a auf. Das Anschlusselement 2 weist eine Ausnehmung 12 auf, durch die die elektrisch isolierte Schraube 1 hindurchgeführt ist.

Im montierten Zustand ist die elektrisch isolierte Schraube 1 durch die Ausnehmung 12 des Anschlusselements 2, durch die Hülse 3 und durch eine Ausnehmung 10 der unteren Leiterlatte 7 hindurchgeführt und in die Gewindebohrung 9 der Grundplatte 8 eingeschraubt. Die in die Gewindebohrung 9 des Grundkörpers 8 eingeschraubte elektrisch isolierte Schraube 1 presst hierbei das Anschlusselement 2 auf die elektrisch leitende Hülse 3, die auf die untere Leiterplatte 7 kontaktiert ist, und presst das Anschlusselement 2 mit der Isolierung bzw. Abdichtung 2a gegen das an dieser Stelle passend ausgeformte Gehäuse 5. Der Schraubenkopf der Schraube 1 ist hierzu an der Unterseite mit einer ersten Anlagefläche 15 versehen, die mit dem Anschlusselement 2 derart in Verbindung bringbar ist, dass das Anschlusselement 2 auf die Hülse 3 gepresst wird, und mit einer zweiten Anlagefläche 16 versehen, die mit der Isolierung bzw. Abdichtung 2a des Anschlusselements 2 derart in Verbindung bringbar ist, dass das das Anschlusselement 2 mit der Isolierung bzw. Abdichtung 2a gegen eine Oberseite des Gehäuses 5 gepresst wird.

Mit der elektrisch isolierten Schraube 1 wird somit eine elektrische Verbindung und Kontaktierung zwischen dem Anschlusselement 2 des leistungselektronischen Anschlusses und der Leiterplatte 7 hergestellt, aber nicht zwischen der Hülse 3 und dem Grundkörper 8, da die elektrische Verbindung zwischen der Hülse 3 und dem Grundkörper 8 von der elektrisch isolierten Schraube 1 verhindert ist. Gleichzeitig wird durch den Anpressdruck der Schraube 1 eine Abdichtung zwischen dem Gehäuse 5 und dem Anschlusselement 2 gewährleistet. Darüber hinaus wird mit der Schraube 1 die untere Leiterplatte 7 an dem Grundkörper 8 fixiert und auf den Grundkörper 8 gepresst.

Die Hülse 3 ist im dargestellten Ausführungsbeispiel durch eine Ausnehmung 11 der oberen Leiterplatte 6 hindurchgeführt, um auf dieser Leiterplatte 6 einen Stromsensor 4 zur Strommessung oder einen Ferritkern zur Bedämpfung von elektromagnetischen Störungen zu platzieren.

Die beim Betrieb der leistungselektronischen Komponente C, insbesondere durch die auf der unteren Leiterplatte 7 angeordneten Leistungshalbleiter, anfallende Abwärme wird durch den direkten Kontakt der Leiterplatte 7 mit dem Grundkörper 8, wobei die Leiterplatte 7 mittel der elektrisch isolierten Schraube 1 auf den Grundkörper 8 gepresst ist, von dem bevorzugt als Kühlkörper ausgebildeten Grundkörper 8 abgeführt.

## Patentansprüche

1. Leistungselektronische Komponente (C) mit einem Grundkörper (8) und einem Gehäuse (5) sowie mindestens einer im Gehäuse (5) untergebrachten Leiterplatte (7) und mindestens einer elektrischen Kontaktierung der Leiterplatte (7) zu einem, außerhalb des Gehäuses (5) vorgesehenen, leistungselektronischen Anschluss, **dadurch gekennzeichnet, dass** die elektrische Kontaktierung der Leiterplatte (7) eine elektrisch leitende Hülse (3) umfasst, die auf die Leiterplatte (7) kontaktiert und aus dem Gehäuse (5) herausgeführt ist, wobei in die elektrisch leitende Hülse (3) eine isolierte Schraube (1) eingesetzt ist, die in eine Gewindebohrung (9) im Grundkörper (8) geschraubt ist und deren Schraubenkopf ein Anschlusselement (2) des leistungselektronischen Anschlusses auf die Hülse (3) und gegen das Gehäuse (5) presst, wobei die Hülse (3) frei von einem elektrischen Kontakt mit dem Grundkörper (8) ist.

2. Leistungselektronische Komponente (C) nach Anspruch 1, **dadurch gekennzeichnet, dass** eine elektrische Verbindung zwischen dem Anschlusselement (2) des leistungselektronischen Anschlusses und der Leiterplatte (7) hergestellt wird, aber nicht zwischen der Hülse (3) und dem Grundkörper (8).

3. Leistungselektronische Komponente (C) nach Anspruch 1 oder 2, **dadurch gekennzeichnet, dass** das Anschlusselement (2) einen Kabelschuh umfasst.

4. Leistungselektronische Komponente (C) nach Anspruch 3, **dadurch gekennzeichnet, dass** der Kabelschuh mit einer umlaufenden Isolierung (2a) versehen ist.

5. Leistungselektronische Komponente (C) nach einem der Ansprüche 1 bis 4, **dadurch gekennzeichnet, dass** das Gehäuse (5) im Bereich des Schraubenkopfes der Schraube (1) eine Ausformung aufweist, die für eine Aufnahme des Schraubenkopfes der Schraube (1) und des Anschlusselements (2) ausgebildet ist.

6. Leistungselektronische Komponente (C) nach einem der Ansprüche 1 bis 5, **dadurch gekennzeichnet, dass** die Leiterplatte (7) mittels der Schraube (1) auf den Grundkörper (8) gepresst ist.

7. Leistungselektronische Komponente (C) nach einem der Ansprüche 1 bis 6, **dadurch gekennzeichnet, dass** der Grundkörper (8) als Grundplatte ausgebildet ist.

8. Leistungselektronische Komponente (C) nach einem der Ansprüche 1 bis 7, **dadurch gekennzeichnet, dass** der Grundkörper (8) einen Kühlkörper umfasst.

9. Leistungselektronische Komponente (C) nach einem der Ansprüche 1 bis 8, **dadurch gekennzeichnet, dass** die Hülse (3) auf der Leiterplatte (7) verlötet oder verpresst ist.

10. Leistungselektronische Komponente (C) nach einem der Ansprüche 1 bis 9, **dadurch gekennzeichnet, dass** oberhalb der Leiterplatte (7) mindestens eine weitere Leiterplatte (6) vorgesehen ist, durch die die Hülse (3) hindurchgeführt ist.

11. Leistungselektronische Komponente (C) nach Anspruch 10, **dadurch gekennzeichnet, dass** auf der weiteren Leiterplatte (6) ein Stromsensor (4) oder einen Ferritkern im Bereich der Durchführung der Hülse (3) angeordnet ist.

12. Leistungselektronische Komponente (C) nach einem der Ansprüche 1 bis 11, **dadurch gekennzeichnet, dass** der Öffnungsbereich der Gewindebohrung (9) aufgeweitet ist.

13. Leistungselektronische Komponente (C) nach einem der Ansprüche 1 bis 12, **dadurch gekennzeichnet, dass** zusätzliche Halterungen vorgesehen sind, durch die die Leiterplatte (7) und die Hülse (3) in einer Ebene fixiert sind.

14. Leistungselektronische Komponente (C) nach einem der Ansprüche 1 bis 13, **dadurch gekennzeichnet, dass** die Leiterplatte (7) und/oder die Hülse (3) im unmontierten Zustand schwimmend gelagert sind.

15. Leistungselektronische Komponente (C) nach einem der Ansprüche 1 bis 14, **dadurch gekennzeichnet, dass** die leistungselektronische Komponente (C) als Umrichter ausgebildet ist.

16. Leistungselektronische Komponente (C) nach einem der Ansprüche 1 bis 14, **dadurch gekennzeichnet, dass** die leistungselektronische Komponente (C) als Ladegerät ausgebildet ist.
